# FASCICULE DE BREVET EUROPEEN

(11) **EP 0 498 695 B1**
(45) Date de publication et mention de la délivrance du brevet: **05.04.1995**
(21) Numéro de dépôt: 92400227.2
(22) Date de dépôt: 29.01.1992
(51) Int. Cl.: H01L 33/00, H01S 3/19

(54) **Procédé de réalisation d'un laser semiconducteur planaire à ruban enterré**
Verfahren zum Herstellen eines planaren Halbleiterlasers mit vergrabener Streifenstruktur
Method of producing a planar stripe-buried semiconductor laser

(30) Priorité: 08.02.1991 FR 9101470
(43) Date de publication de la demande: 12.08.1992
(73) Titulaire: ALCATEL N.V., NL-1077 XX Amsterdam (NL)
(72) Inventeur: Goldstein, Léon, F-92370 Chaville (FR); Bonnevie, Dominique, F-91310 Leuville sur Orge (FR); Brillouet, François, F-92310 Sevres (FR); Poingt, Francis, F-91700 Sainte Genevieve des Bois (FR); Lievin, Jean-Louis, F-7502 Paris (FR)
(74) Mandataire: Bourely, Paul

(56) Documents cités:
- EP-A- 0 192 450
- EP-A- 0 359 542
- PATENT ABSTRACTS OF JAPAN vol. 12, no. 449 (E-686)25 Novembre 1988
- APPLIED PHYSICS LETTERS. vol. 51, no. 12, 21 Septembre 1987, NEW YORK US pages874 - 876; H. ISHIGURO ET AL.: 'Very low threshold planar buried
- heterostructure InGaAsP/InP laser diodes prepared by three-stage metalorganicchemical vapor desposition'
- APPLIED PHYSICS LETTERS. vol. 59, no. 12, 16 Septembre 1991, NEW YORK US pages1407 - 1408; J.-L. LIEVIN ET AL.: 'Buried heterostructure laser fabricatedusing three-step gas source molecular beam epitaxy'

## Description

La présente invention est relative à un laser semiconducteur du type à ruban enterré. La structure semiconductrice d'un tel laser est internationalement désignée par l'appellation "planar buried heterojunction" (PBH).

Des procédés connus de fabrication d'un tel laser comporte des étapes dites de croissance de couches au cours desquelles on fait croître l'épaisseur de couches semiconductrices par dépôt épitaxial du matériau de ces couches. Il peut être succinctement décrit de la manière suivante.
- Croissance de couches semiconductrices à composition binaire, puis quaternaire, puis binaire sur un substrat. On réalise ainsi une double hétérostructure.
- Définition d'un ruban laser dans la couche à composition quaternaire par gravure chimique à partir de la face supérieure du substrat en utilisant un masque diélectrique.
- Croissance de deux couches semiconductrices latérales pour entourer et enterrer le ruban laser.

Cette étape de croissance de couches latérales peut utiliser des méthodes de croissance dites "sélectives" qui présentent divers inconvénients tels qu'un rendement limité. Elle peut aussi utiliser une méthode de croissance non sélective qui fait croître le matériau semi-conducteur non seulement sur les cotés du ruban laser mais aussi au-dessus de celui-ci en créant une saillie parasite. Dans ce cas il est connu, avant la définition du ruban laser, de faire croître une couche d'aide au retrait (dite parfois de lift-off, ou stencil), dont la partie subsistante sous la saillie parasite pourra ultérieurement être attaquée chimiquement et sélectivement pour séparer et évacuer cette saillie. Un tel procédé est décrit dans les documents PATENT ABSTRACTS OF JAPAN, vol; 12, no. 449 (E-686); 25 novembre 1988 ; et JP-A-63 177 493 (NIPPON TELEGR. & TELEPH. CORP. NTT) 21-07-1988. Son efficacité semble aléatoire.

La présente invention a notamment les buts suivants :
- augmenter l'efficacité d'un procédé de réalisation d'un laser semiconducteur du type planaire à ruban enterré,
- permettre d'utiliser, dans le cadre de ce procédé, des méthodes de croissance non sélective à rendement élevé,
- et, de manière générale, permettre d'utiliser, dans le cadre de ce procédé, des méthodes susceptibles de présenter des avantages par rapport aux méthodes précédemment employées.

Selon cette invention, on forme les couches semiconductrices latérales par une méthode de croissance non sélective et on ménage des intervalles de passage pour un milieu d'attaque sélective permettant d'éliminer une bande d'aide au retrait sous la saillie parasite que l'emploi d'une telle méthode non sélective a formée au-dessus du ruban laser.

A l'aide des figures schématiques ci-jointes, on va décrire ci-après comment la présente invention peut être mise en oeuvre, étant entendu que les éléments et dispositions mentionnés et représentés ne le sont qu'à titre non limitatif. Lorsqu'un même élément est représenté sur plusieurs figures il y est désigné par le même signe de référence. Lorsqu'une couche a été désignée par un numéro de référence, une fraction de cette couche peut être désignée par le même numéro de référence complété par la lettre A.

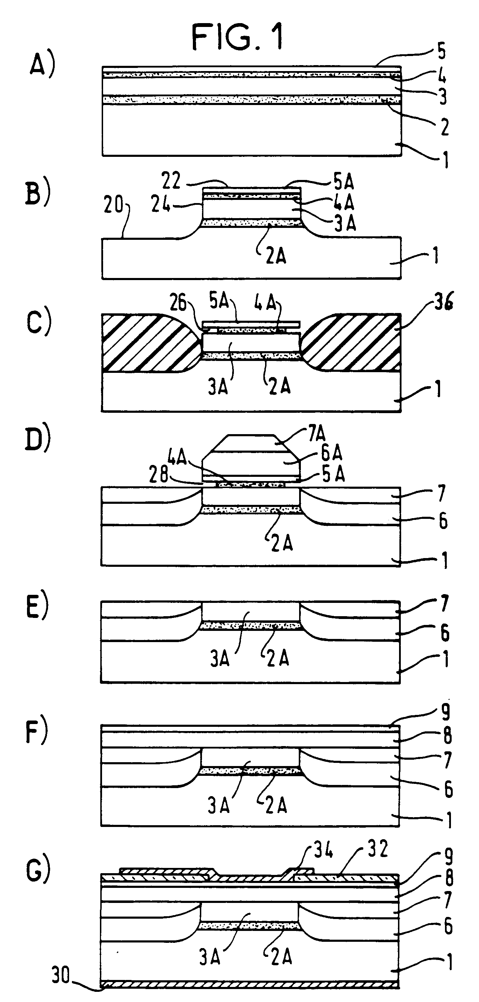

Les figures 1A à 1G représentent des vues en coupe d'un substrat semiconducteur après des étapes successives de la réalisation d'un laser selon la présente invention.

Le procédé selon la présente invention tel que défini en revendication 1, comporte d'abord une étape de formation d'une couche de confinement inférieure 1 constituée d'un matériau de base semiconducteur d'un premier type de conductivité. Il comporte ensuite les étapes suivantes :
- Croissance d'une couche active 2 constituée d'un matériau actif.
- Croissance d'une première couche de confinement supérieure 3 constituée dudit matériau de base présentant le deuxième type de conductivité.
- Gravure de définition de ruban. Cette gravure élimine localement au moins la couche active et la première couche de confinement supérieure en creusant deux vallées 20 de part et d'autre d'un ruban laser 2A constitué par une portion restante de cette couche active. Ce ruban et les couches qui le surmontent forment un plateau 22 qui subsiste en relief et qui se raccorde par deux flancs 24 à ces deux vallées.
- Croissance de couches latérales 6, 7 constituées d'un matériau latéral pour entourer ce ruban laser.

Les indices de réfraction, types de conductivité et résistivité électrique de ces couches de confinement, active et latérales sont choisis, dans au moins des parties de ces couches, pour réaliser un confinement optique dans ce ruban laser et pour que le passage d'un courant électrique d'alimentation entre ces couches de confinement soit localisé à travers ce ruban laser et y injecte des porteurs de charges permettant l'amplification d'une lumière que le laser devra émettre.
- Une étape ultérieure est la formation de moyens de connexion électrique 30, 32, 34 pour permettre de faire passer ledit courant d'alimentation.

On va maintenant décrire de manière générale des dispositions liées à l'utilisation des méthodes de croissance non sélective: Deux étapes de croissance sont réalisées après ladite étape de croissance d'une première couche de confinement supérieure et avant ladite étape de gravure de définition de ruban :
- croissance d'une couche d'aide au retrait 4 constituée d'un matériau d'aide au retrait sélectivement attaquable par voie chimique,
- et croissance d'une couche de protection 5 sur cette couche d'aide au retrait (Fig. 1A).

L'étape de gravure de définition de ruban élimine ensuite ces couches d'aide au retrait et de protection de part et d'autre du ruban laser 2A en les laissant subsister au-dessus de ce ruban sous forme de bandes d'aide au retrait 4A et de protection 5A qui forment la partie haute du plateau 22 au-dessus de ce ruban. Ce plateau comporte aussi une bande de confinement supérieure 3A constituée par la fraction restante de la première couche de confinement supérieure 3 (Fig. 1B).

L'étape de croissance de couches latérales est ensuite réalisée par une méthode de croissance non sélective qui fait croître ledit matériau latéral non seulement dans les vallées 20 pour former les couches latérales 6 et 7 mais aussi sur la bande de protection 5A en formant une saillie parasite 6A, 7A au-dessus du plateau 22 (Fig. 1D).

Ce procédé comporte encore une étape de sous-gravure effectuée après l'étape de gravure de définition de ruban et avant l'étape de croissance de couches latérale:. Cette étape de sous-gravure est effectuée à l'aide d'un milieu d'attaque de retrait qui attaque sélectivement ledit matériau d'aide au retrait pour éliminer deux zones latérales de la bande d'aide au retrait 4A. Elle forme ainsi un creux 26 (fig. 1C) sous chacun des bords de la saillie parasite 6A, 7A, de sorte que l'étape de croissance de couches latérales fait ensuite apparaître deux intervalles 28 entre d'une part la fraction du matériau latéral qui constitue cette saillie 6A, 7A, d'autre part les deux dites couches latérales 6 et 7. Ces intervalles constituent des passages qui sont ouverts à partir de l'extérieur vers les bords de la bande d'aide au retrait 4A (Fig. 2D), et qui seront utilisés par la suite.

En effet ce procédé comporte encore, après l'étape de croissance de couches latérales et avant ladite étape de formation de moyens de connexion électrique, une étape de retrait de saillie qui est effectuée à l'aide d'un dit milieu d'attaque de retrait. Au cours de cette étape, ce milieu passe à travers ces passages 28, atteint les bords de la bande d'aide au retrait 4A et poursuit l'élimination de cette bande pour séparer la saillie parasite 6A, 7A de la première bande de confinement supérieure 3A. Cette séparation provoque un retrait ultérieur de cette saillie.

La présente invention s'applique notamment au cas où le matériau actif 2 est sensible audit milieu d'attaque de retrait. Dans ce cas, le procédé comporte, après l'étape de gravure de définition de ruban et avant l'étape de sous-gravure, une étape de protection de ruban pour protéger les bords du ruban laser 2A. De préférence cette étape de protection de ruban comporte elle-même les étapes suivantes :
- dépôt d'une couche de résine protectrice 36 sur les vallées 20, le plateau 22 et ses flancs 24, cette résine constituant une protection contre ce milieu d'attaque de retrait,
- et ablation ménagée de cette résine pour la laisser subsister seulement dans ces vallées et sur une partie inférieure de ces flancs, cette partie comportant les bords du ruban laser.

De préférence encore, cette étape d'ablation ménagée de résine est localisée sur le plateau 22 et au voisinage de celui-ci. Elle est alors suivie d'une étape de fluage de résine au cours de laquelle la résine protectrice 36 est placée dans des conditions de fluage qui lui donnent temporairement une fluidité suffisante pour que ses forces de tension superficielle la fasse migrer vers ce plateau et accroissent et régularisent sa hauteur le long des flancs 24 de ce plateau. Cette étape de fluage est par exemple réalisée par chauffage.

Ces diverses dispositions s'appliquent avec avantage dans le cas suivant : lesdits matériaux de base et latéral ont une composition intrinsèque binaire, et sont plus particulièrement constitués de phosphure d'indium ou d'arseniure de gallium avec des dopages appropriés divers pour constituer les couches précédemment indiquées. Quant auxdits matériaux actifs et d'aide au retrait, ils ont une composition intrinsèque ternaire et/ou quaternaire qui inclue en outre du gallium, de l'aluminium et/ou de l'arsenic.

On va maintenant décrire la succession chronologique des étapes précédemment mentionnées, ceci dans le cadre plus particulier d'un exemple de mise en oeuvre de la présente invention.

La figure 1A représente le résultat d'une première étape de croissance. Sur un substrat semiconducteur d'InP dopé n constituant la couche de confinement inférieure 1, on effectue diverses opérations au cours desquelles, notamment, on dépose successivement les couches suivantes :
- La couche active 2 (épaisseur 100 à 300 nm) de matériau GaInAsP par exemple. Cette couche formera la double hétérostructure du laser,
- La première couche de confinement supérieure 3 (matériau InP dopé p par exemple) (800 nm),
- La couche d'aide au retrait 4. Elle est destinée à permettre un retrait par une méthode de retrait connue internationalement sous l'appellation "lift-off". Le matériau d'aide au retrait qui la constitue est un arseniure d'indium et de gallium InGaAs par exemple (environ 300 nm),
- La couche de protection 5 (matériau InP) (300 nm). Elle protégera la couche 4.

L'étape de gravure permet ensuite de délimiter le ruban laser 2A. Elle forme en même temps le plateau 22, couramment appelé mésa, de largeur 100 à 300 nm par exemple (Fig. 1B). On utilise les techniques de gravure classiques.

On réalise ensuite l'étape de protection du ruban laser. On dépose pour cela une résine protectrice dont on effectue une ablation ménagée dans une zone incluant ce plateau. Après une étape de fluide de cette résine, celle-ci prend la forme représentée sur la Fig. 1C et constitue une protection pour les bords du ruban laser 2A tout en laissant exposés ceux de la bande d'aide au retrait 4A.

On effectue alors, à l'aide d'un milieu d'attaque de retrait de composition connue (par exemple H₂SO₄, H₂O₂, H₂O en proportion volumique 1-1 et 20, respectivement, à température ambiante, pendant 20 s) une attaque chimique sélective qui constitue l'étape de sous-gravure de la bande 4A; Le résultat obtenu est représenté Fig. 1C.

La croissance des couches latérales 6 et 7, respectivement dopées p et n, permet d'enterrer le ruban laser 2A. Le matériau latéral qui les constitue est le phosphure d'indium InP. La méthode de croissance utilisée ne présente pas de caractère sélectif. Elle peut être en particulier l'EJM (épitaxie par jets moléculaires) ainsi que l'EPVOM (épitaxie en phase vapeur des composés organo-métalliques) utilisée à pression atmosphérique notamment. Cette méthode non sélective donne lieu à la croissance d'une saillie constituée par des bandes 6A et 7A sur le plateau 22, c'est-à-dire sur la bande 5A. L'étape de sous-gravure permet d'introduire une discontinuité du matériau latéral entre cette saillie et ces couches latérales. Cette discontinuité constitue les intervalles 28 précédemment mentionnés. Il faut noter que l'on peut substituer aux couches 6 et 7 une succession de couches comportant une couche d'InP semi-isolante dopée au fer.

Au cours de l'étape de retrait, une attaque sélective de la bande 4A permet, à l'aide par exemple du même milieu d'attaque utilisé pendant une durée plus grande que précédemment, d'éliminer cette bande, ce qui permet le retrait de la saillie 6A, 7A (Fig. 1E).

Une étape de croissance consiste alors à déposer une deuxième couche de confinement supérieure 8 et une couche de contact 9. On obtient ainsi la structure semiconductrice complète d'un laser à ruban enterré (Fig. 1F).

La réalisation du composant laser final est obtenue par les procédés technologiques classiques qui comportent le dépôt et la gravure d'une couche diélectrique 32 et le dépôt d'électrodes 30 et 34 pour constituer des moyens de connexion électrique.

L'invention n'est pas limitée au laser décrit ci-dessus, qui émet à une longueur d'onde de 1,5 micron et qui n'a été décrit qu'à titre d'exemple.

## Revendications

1. Procédé de réalisation d'un laser semiconducteur planaire à ruban enterré, ce procédé comportant une étape de formation d'une couche de confinement inférieure (1) constituée d'un matériau de base semiconducteur d'un premier type de conductivité,
- ce procédé comportant ensuite d'autre étapes dont certaines sont des étapes de croissance de couches pour effectuer des dépôts épitaxiaux de couches semiconductrices sur des couches sous-jacentes, ces autres étapes étant notamment les suivantes :
- croissance d'une couche active (2) constituée d'un matériau actif,
- puis croissance d'une première couche de confinement supérieure (3) constituée dudit matériau de base présentant le deuxième type de conductivité,
- puis croissance d'une couche d'aide au retrait (4) constituée d'un matériau d'aide au retrait sélectivement attaquable par voie chimique,
- gravure de définition de ruban, cette gravure éliminant localement au moins lesdites couche active (2), première couche de confinement supérieure (3) et couche d'aide au retrait en creusant deux vallées (20) de part et d'autre d'un plateau (22) qui subsiste en relief et qui se raccorde par deux flancs (24) à ces deux vallées, ce plateau comportant un ruban laser (2A), une bande de confinement supérieure (3A) et une bande d'aide au retrait (4A) constitués par les portions restantes de cette couche active, de cette première couche de confinement supérieure, et de cette couche d'aide au retrait, respectivement,
- croissance de couches latérales (6, 7) constituées d'un matériau latéral pour entourer ce ruban laser, cette étape de croissance de couches latérales étant réalisée par une méthode de croissance non sélective qui fait croître ledit matériau latéral non seulement dans lesdites vallées pour former lesdites couches latérales (6, 7), mais aussi sur ce plateau (22) en formant une saillie parasite (6A, 7A) au-dessus de ce plateau, les indices de réfraction, types de conductivité et résistivités électriques de ces couches de confinement, active et latérales, étant choisis, dans au moins des parties de ces couches, pour réaliser un confinement optique dans ce ruban laser et pour que le passage d'un courant électrique d'alimentation entre ces couches de confinement soit localisé à travers ce ruban laser et y permettent l'amplification d'une lumière,
- ce procédé comportant ensuite une étape de retrait de saillie effectuée à l'aide d'un milieu d'attaque de retrait qui attaque sélectivement ledit matériau d'aide au retrait pour détruire ladite bande d'aide au retrait (4A) et séparer ladite saillie parasite (6A, 7A) de ladite première bande de confinement supérieure (3A),
- et formation de moyens de connexion électrique (30, 32, 34) pour permettre de faire passer ce courant d'alimentation,
- ce procédé étant caractérisé par le fait qu'il comporte en outre, avant ladite étape de gravure de définition de ruban, une étape de croissance d'une couche de protection (5) sur ladite couche d'aide au retrait (4), de sorte que ladite étape de gravure de définition de ruban élimine ensuite aussi cette couche de protection de part et d'autre dudit ruban laser (2A) en la laissant subsister au-dessus de ce ruban sous forme d'une bande de protection (5A) pour former ledit plateau (22) au-dessus de ce ruban, (3),
- ce procédé comportant encore, après cette étape de gravure de définition de ruban et avant cette étape de croissance de couches latérales, une étape de sous-gravure effectuée à l'aide d'un dit milieu d'attaque de retrait pour éliminer deux zones latérales de ladite bande d'aide au retrait (4A) en formant un creux (26) sous chacun des bords de ladite saillie parasite (6A, 7A) de sorte que cette étape de croissance de couches latérales fait ensuite apparaître deux intervalles (28) entre les fractions dudit matériau latéral qui constituent d'une part cette saillie (6A, 7A), d'autre part les deux dites couches latérales (6, 7), et que, lors de ladite étape de retrait de saillie, ledit milieu d'attaque de retrait passe à travers ces intervalles (28) pour détruire ladite bande d'aide au retrait (4A).

2. Procédé selon la revendication 1, dans lequel ledit matériau actif (2) est sensible audit milieu d'attaque de retrait, ce procédé étant caractérisé par le fait qu'il comporte, après ladite étape de gravure de définition de ruban et avant ladite étape de sous-gravure, une étape de protection de ruban pour protéger les bords dudit ruban laser (2A).

3. Procédé selon la revendication 2, caractérisé par le fait que ladite étape de protection de ruban comporte elle-même les étapes suivantes :
- dépôt d'une couche de résine protectrice (30) sur lesdites vallées (20), ledit plateau (22) et ses dits flancs (24), cette résine constituant une protection contre ledit milieu d'attaque de retrait,
- et ablation ménagée de cette résine pour la laisser subsister seulement dans lesdites vallées et sur une partie inférieure de ces flancs, cette partie comportant les bords dudit ruban laser (2A).

4. Procédé selon la revendication 3, caractérisé par le fait que ladite étape d'ablation ménagée de résine est localisée sur ledit plateau (22) et au voisinage de celui-ci, cette étape étant suivie d'une étape de fluage de résine au cours de laquelle ladite résine protectrice (36) est placée dans des conditions de fluage qui lui donnent temporairement une fluidité suffisante pour que ses forces de tension superficielle la fasse migrer vers ce plateau et accroissent et régularisent sa hauteur le long des flancs (24) de ce plateau.

5. Procédé selon la revendication 1, lesdits matériaux de base et latéral étant un même matériau de composition intrinsèque binaire, lesdits matériaux actif et d'aide au retrait étant des matériaux de compositions intrinsèques ternaire et/ou quaternaire.

6. Procédé selon la revendication 5, lesdits matériaux de base et latéral étant du phosphure d'indium ou de l'arseniure de gallium, lesdits matériaux actif et d'aide au retrait comportant en outre du gallium, de l'aluminium et/ou de l'arsenic.

## Patentansprüche

1. Verfahren zur Herstellung eines planaren Halbleiterlasers mit eingebettetem Laserband, wobei das Verfahren einen Verfahrensschritt der Bildung einer unteren Einschließungsschicht (1), die aus einem Halbleiter-Basismaterial eines ersten Leitfähigkeitstyps gebildet wird, und dann weitere Schritte aufweist, von denen einige das Aufwachsen von Schichten betreffen, um Epitaxial-Halbleiterschichten auf darunterliegende Schichten aufzubringen, wobei diese weiteren Schritte insbesondere folgender Art sind:
- Aufwachsen einer aktiven Schicht (2) aus einem aktiven Material,
- dann Aufwachsen einer ersten oberen Einschließungsschicht (3) bestehend aus dem Basismaterial, das den zweiten Leitfähigkeitstyp hat,
- dann Aufwachsen einer Entfernungs-Hilfsschicht (4) bestehend aus einem Entfernungs-Hilfsmaterial, das selektiv auf chemische Weise entfernt werden kann,
- Abätzen zur Definition des Bandes, wobei lokal mindestens die aktive Schicht (2), die erste obere Einschließungsschicht (3) und die Entfernungs-Hilfsschicht entfernt werden und sich zwei Täler (20) zu beiden Seiten eines dann reliefartig vorstehenden Plateaus (22) bilden, wobei dieses Plateau über zwei Flanken (24) in diese beiden Täler übergeht und ein Laserband (2A), ein oberes Einschließungsband (3A) und ein EntfernungsHilfsband (4A) enthält, die aus den verbleibenden Bereichen der aktiven Schicht, der ersten oberen Einschließungsschicht und der Entfernungs-Hilfsschicht gebildet werden,
- Aufwachsen von seitlichen Schichten (6, 7) aus einem seitlichen Material, um das Laserband zu umgeben, wobei dieser Schritt durch eine nicht-selektive Wachstumsmethode erfolgt, bei der das seitliche Material nicht nur in den Tälern wächst, um die seitlichen Schichten (6, 7) zu bilden, sondern auch auf diesem Plateau (22), indem eine störende Ablagerung (6A, 7A) auf diesem Plateau erfolgt, wobei die Brechungsindices, die Leitfähigkeitstypen und die spezifischen elektrischen Widerstände der Einschließungsschicht, der aktiven und der seitlichen Schichten zumindest in Teilen dieser Schichten so gewählt werden, daß sich eine optische Einschließung des Lichts in diesem Laserband ergibt und daß der Durchgang eines elektrischen Speisestroms zwischen diesen Einschließungsschichten durch das Laserband lokalisiert wird und dort eine Lichtverstärkung erlaubt,
- dann Entfernung der störenden Ablagerung mit Hilfe eines Entfernungs-Ätzmittels enthält, das selektiv das EntfernungsHilfsmaterial angreift, um das Entfernungs-Hilfsband (4A) zu zerstören und die störende Ablagerung (6A, 7A) vom ersten oberen Einschließungsband (3A) zu trennen,
- und Bildung von elektrischen Anschlußmitteln (30, 32, 34), um den Speisestrom durchfließen zu lassen,
- dadurch gekennzeichnet, daß das Verfahren außerdem vor dem Abätzen zur Definition des Laserbands einen Schritt aufweist, bei dem eine Schutzschicht (5) auf die Entfernungs-Hilfsschicht (4) so aufgebracht wird, daß beim Abätzen zur Definition des Laserbands dann auch diese Schutzschicht zu beiden Seiten des Laserbands (2A) entfernt wird, so daß nur noch oberhalb dieses Bands ein Schutzband (5A) verbleibt, das das Plateau (22) oberhalb des Bandes (3) bildet,
- wobei das Verfahren weiter nach dem Abätzen zur Definition des Laserbands und vor dem Aufwachsen von seitlichen Schichten einen Verfahrensschritt des Unterätzens aufweist, der mit Hilfe eines Entfernungs-Ätzmittels erfolgt, um zwei seitliche Zonen des Entfernungs-Hilfsbands (4A) zu entfernen und eine Höhlung (26) unter jedem der Ränder der störenden Ablagerung (6A, 7A) zu bilden, so daß sich beim Aufwachsen von seitlichen Schichten zwei Abstände (28) zwischen den Bereichen des seitlichen Materials, die diese Ablagerung (6A, 7A) bilden, und den beiden seitlichen Schichten (6, 7) ergeben und daß während der Entfernung der Ablagerung das Entfernungs-Ätzmittel durch diese Abstände (28) eindringt, um das Entfernungs-Hilfsband (4A) zu zerstören.

2. Verfahren nach Anspruch 1, bei dem das aktive Material (2) für das Entfernungs-Ätzmittel empfindlich ist, dadurch gekennzeichnet, daß nach dem Schritt des Ätzens der Definition des Laserbands und vor dem Unter-Ätzen ein Verfahrensschritt eingefügt wird, bei dem die Ränder des Laserbands (2A) geschützt werden.

3. Verfahren nach Anspruch 2, dadurch gekennzeichnet, daß der Verfahrensschritt des Schutzes des Laserbands seinerseits die folgenden Verfahrensschritt aufweist:
- Aufbringen einer Schutzschicht (36) aus Harz auf die Täler (20), das Plateau (22) und dessen Flanken (24), wobei dieses Harz einen Schutz gegen das Entfernungs-Ätzmittel bildet,
- und Abtragen des Harzes, so daß es nur in den Tälern und auf einem unteren Bereich der Flanken verbleibt, der die Ränder des Laserbands (2A) enthält.

4. Verfahren nach Anspruch 3, dadurch gekennzeichnet, daß der Verfahrensschritt des Abtragens des Harzes auf das Plateau (22) und dessen unmittelbare Umgebung begrenzt wird und auf diesen Verfahrensschritt ein Verfahrensschritt folgt, bei dem das Schutzharz (36) flüssig gemacht wird, derart, daß es vorübergehend ausreichend flüssig wird, damit seine Oberflächenspannungskräfte dieses Harz zum Plateau wandern lassen und dessen Höhe entlang der Flanken (24) des Plateaus vergrößern und vergleichmäßigen.

5. Verfahren nach Anspruch 1, bei dem das Basismaterial und das seitliche Material die gleiche intrinsisch binäre Zusammensetzung besitzen und das aktive Material sowie das Entfernungs-Hilfsmaterial intrinsisch binär und/ode quaternär zusammengesetzt sind.

6. Verfahren nach Anspruch 5, bei dem das Basismaterial und das seitliche Material Indiumphosphid oder Galliumarsenid sind und das aktive Material sowie das Entfernungs-Hilfsmaterial außerdem Gallium, Aluminium und/oder Arsen enthalten.

## Claims

1. Method of manufacturing a planar buried heterojunction laser including a stage in which is formed a lower confinement layer (1) consisting of a semiconductor base material having a first type of conductivity,
- the method comprising subsequent other steps including layer growing steps for epitaxial deposition of semiconductor layers on underlying layers, said other steps including:
- growth of an active layer (2) of an active material,
- then, growth of a first upper confinement layer (3) of said base material having the second type of conductivity,
- then, growth of a lift-off layer (4) of a lift-off material that can be selectively attacked by chemical means,
- etching to define the boundaries of said laser stripe by locally eliminating at least said active layer (2), said first upper confinement layer (3) and said lift-off layer by etching two valleys (20) one on each side of an upstanding mesa (22) joined by two flanks (24) to said valleys, said mesa comprising a laser stripe (2A), an upper confinement layer (3A) and a lift-off layer (4A) consisting of the remaining portions of said active layer, said first upper confinement layer and said lift-off layer, respectively,
- growth of lateral layers (6, 7) surrounding said laser stripe by a non-selective growth method whereby said lateral layer material is grown not only in said valleys for forming said lateral layers (6, 7) but also on said mesa (22) to form a parasitic projection (6A, 7A) above said mesa, the refractive indices, types of electrical conductivity and resistivity of said confinement, active and lateral layers being selected in parts at least of said layers to establish optical confinement in said laser stripe and so that the passage of a current between said confinement layers is localised through said laser stripe and enables light amplification to take place therein,
- a projection removal step carried out using a lift-off attacking medium to selectively attack said lift-off material (4A) in order to separate said parasitic projection (6A, 7A) from said first upper confinement stripe (3A), and
- formation of electrical connection means (30, 32, 34) for said current,
- this method being characterised in that it further comprises, before said stripe boundary definition etching stage,
- growth of a protective layer (5) on said lift-off layer (4) whereby said laser stripe boundary definition etching stage eliminates said protection layer at both sides of said laser stripe (2A) while allowing it to remain above said stripe in the form of a protective stripe (5A) for forming said mesa (22) above said stripe (3),
- this method further comprising, after said stripe boundary definition etching stage and before said lateral layer growth stage,
- a sub-etching step carried out using a lift-off attacking medium to eliminate two lateral zones of said lift-off stripe (4A) and form a hollow (26) under each edge of said parasitic projection (6A, 7A) whereby said lateral layer growth step causes the appearance of two gaps (28) between the respective portions of said lateral layer material which constitute said projection (6A, 7A) and said two lateral layers (6, 7), so that during said projection removal stage said lift-off attacking medium passes through said gaps (28) to eliminate said lift-off stripe (4A).

2. Method according to claim 1 wherein said active material (2) is sensitive to said lift-off attacking medium and characterised in that it comprises after said stripe boundary definition etching step and prior to said sub-etching step a laser stripe protection step for protecting the edges of said laser stripe (2A).

3. Method according to claim 2 characterised in that said laser stripe protection step includes:
- deposition of a layer (30) of resin constituting protection against said lift-off attacking medium on said valleys (20), said mesa (22) and said flanks (24) thereof, and
- careful removal of said resin whereby it is allowed to remain only in said valleys and on a lower part of said flanks comprising the edges of said laser stripe (2A).

4. Method according to claim 3 characterised in that said resin removal step is localised on said mesa (22) and in the region thereof and is followed by a step in which sufficient fluidity is imparted to said protective resin (36) for its surface tension forces to cause it to migrate towards said mesa with an increase in and evening out of its height along the flanks (24) of the mesa.

5. Method according to claim 1 wherein said base material and said lateral layer material are the same material with a binary intrinsic composition and said active material and said lift-off material are ternary and/or quaternary intrinsic compositions.

6. Method according to claim 5 wherein said base material and said lateral layer material are indium phosphide or gallium arsenide and said active material and said lift-off material further include gallium, aluminum and/or arsenic.
